# EUROPÄISCHE PATENTSCHRIFT

(11) **EP 0 550 003 B1**
(45) Veröffentlichungstag und Bekanntmachung des Hinweises auf die Patenterteilung: **17.01.1996**
(21) Anmeldenummer: 92121849.1
(22) Anmeldetag: 23.12.1992
(51) Int. Cl.: C23C 14/56, C23C 14/50, C23C 16/54

(54) **Vakuumbehandlungsanlage und deren Verwendungen**
Vacuum treatment apparatus and its applications
Appareillage de traitement sous vide et ses utilisations

(30) Priorität: 27.12.1991 CH 3851/91
(43) Veröffentlichungstag der Anmeldung: 07.07.1993
(73) Patentinhaber: BALZERS AKTIENGESELLSCHAFT, FL-9496 Balzers (LI)
(72) Erfinder: Mathis, Reinhard, Dr. Dipl. Mach. Ing., FL-9496 Balzers (LI)
(74) Vertreter: Troesch Scheidegger Werner AG

(56) Entgegenhaltungen:
- EP-A- 0 254 205
- DE-A- 2 241 634
- US-A- 3 892 198
- US-A- 4 938 858

## Beschreibung

Die vorliegende Erfindung betrifft eine Vakuumbehandlungsanlage gemäss Oberbegriff von Anspruch 1.

Für die Vakuumbehandlung von Werkstücken, darunter alle bekannten Behandlungsarten, wie PVD (physical vapor deposition), CVD (chemical vapor deposition) und alle Mischformen der genannten beiden Prinzipien, so beispielsweise plasmaunterstütztes CVD, reaktives Sputtern etc., ist es geläufig, Vakuumbehandlungskammern der Anlagen einzusetzen, welche innen ein in allen Richtungen zusammenhängendes, geschlossenes Volumen definieren, im Sinne eines dreidimensionalen, in allen drei Dimensionen zusammenhängenden Raumabschnitts.

Aufgrund der in diesen bekannten Kammern lokal angeordneten Elektrodenanordnungen für Plasmaentladungsstrecken, Gaseinlässe, insbesondere für reaktive Prozesse, Trägeranordnungen für Werkstücke etc., ist es bei solcher Kammerauslegung und gegebenen Kammervolumen kaum möglich, sowohl die Erfordernis homogener Behandlungsverhältnisse über eine Vielzahl gleichzeitig zu behandelnder Werkstücke sicherzustellen und gleichzeitig das zur Verfügung stehende Kammervolumen für die höchstmögliche Zahl gleichzeitig zu behandelnder Werkstücke auszunützen. Es besteht in solchen Kammern, je nach Prozess mit unterschiedlichem Masse, ein sich durch das Kammervolumen erstreckender Behandlungsgradient, mit anderen Worten kann eine homogene, gleichförmige Behandlungswirkung, wie erwähnt, nur schwer über die an sich zur Verfügung stehenden Volumina aufrechterhalten werden.

Aus der DE-OS 22 41 634, entsprechend der US-PS 3 856 654, ist eine Anlage mit einem Vakuumrezipienten für Werkstücke bekannt geworden, worin ein ringförmiger Behandlungsraum definiert ist. Die Werkstücke sind an einer zylinderförmigen Trägeranordnung im ringförmigen Behandlungsraum gelagert und werden bezüglich der Achse des Behandlungsraumes parallel und einzeln der Trägeranordnung im Behandlungsraum zugespiesen bzw. davon entfernt. Dies erfolgt durch die Wirkung eines Lade-/Entladeschiebers, der in einer fixen Drehposition der Trägeranordnung auf letztere eingreift.

Nachteilig an diesem Vorgehen, das auf dem Prinzip "first in, first out" beruht, ist, dass eine über die Zeit optimal homogene, ungestörte, gleichförmige Behandlungswirkung an den Werkstücken, mit welchen der Behandlungsraum chargiert ist, nur schwer realisierbar ist, und zwar aufgrund des Störeingriffes bei jeder Lade-/Entladeoperation.

Es ist weiter aus der US-PS 3 892 198 bekannt, eine drehgetriebene Trägerkalotte für Werkstücke in einem zylindrischen Rezipienten einer Vakuumbehandlungsanlage dadurch zu beschicken, dass grossflächig ein Teil der Zylinderfläche des Rezipienten als Türe geöffnet werden kann.

Dabei erfolgt die Werkstückbehandlung ab einer zentrischen Quelle.

Nachteilig an dieser Anlage ist, dass der Behandlungsraum schlecht ausgenützt ist und eine gleichförmige Behandlungswirkung der Werkstücke auf der Trägerkalotte trotz Drehbewegung nicht sichergestellt ist.

Es ist Aufgabe der vorliegenden Erfindung, ausgehend von einer Anlage letztgenannter Art, diesen Nachteil zu beheben.

Dies wird an der Vakuumbehandlungsanlage eingangs genannter Art durch ihre Ausbildung nach dem Wortlaut des kennzeichnenden Teils von Anspruch 1 erreicht.

Dadurch, dass der Behandlungsraum zwischen zwei koaxialen Flächen gebildet ist und dabei grossflächig geöffnet werden kann, um ihn gesamthaft zu chargieren bzw. zu entladen, ergibt sich die Möglichkeit, die einmal in den Behandlungsraum eingebrachten Werkstücke gleichzeitig so lange ungestört und insbesondere auch kontinuierlich frei von Beschleunigungsphasen zu bewegen und homogen gleichförmig zu behandeln, bis die angestrebte Behandlung abgeschlossen ist. Auch wenn an der erfindungsgemässen Anlage die im Behandlungsraum eingebrachten Werkstücke in Schritten bewegt werden, ergibt sich trotzdem die Möglichkeit, Beschleunigungs- und Abbremsphasen so auszulegen, dass die dadurch bewirkte Störung der Behandlung vernachlässigbar wird.

Bei der Anlage gemass der US-PS 3 892 198 ist nämlich der Behandlungsraum nicht ringförmig ausgebildet, was erst - bei gegebener Anzahl gleichzeitig zu behandelnder Werkstücke - eine Minimalisierung des Behandlungsraumvolumens bei gleichzeitigem Erzielen einer gleichförmigen Behandlungswirkung entlang der ganzen Bewegungsbahn der Werkstücke durch den Behandlungsraum ermöglicht.

Indem nämlich erfindungsgemäss der Behandlungsraum zwischen zwei koaxialen Flächen gebildet ist, wird erreicht, dass er in seiner Abwicklung ausgesprochen lang wird und trotzdem optimal wenig Platz beansprucht.

Die Werkstücke "sehen" dann in jeder Drehposition gleiche Raumverhältnisse.

Im weiteren wird der Behandlungsraum zwischen den zylindrischen, koaxialen Flächen als "ringförmig" bezeichnet.

Auf dem erfindungsgemässen Konzept beruhend, wurden Anlagen realisiert, mit einem Aussendurchmesser des ringförmigen Behandlungsraumes von mehr als 1m und einer Ringraumbreite im Zentimeterbereich, wie beispielsweise mit einer Breite von ca. 7cm, Masse, die das oben Erläuterte klar manifestieren.

In einer bevorzugten Ausführungsvariante nach dem Wortlaut von Anspruch 2 weist der ringförmige Behandlungsraum an seiner Innen- und/oder Aussenfläche umlaufende Elektroden auf, womit, durch diese koaxiale Elektrodenanordnung entlang des Behandlungsraumes azimutal homogen eine Plasmaentladung im Behandlungsraum erzeugt wird, sei dies zwischen Innen- und Aussenfläche, zwischen Innenfläche und Werkstückträgern und/-oder zwischen Aussenfläche und Werkstückträgern.

Bei einer weiteren bevorzugten Ausführungsvariante nach dem Wortlaut von Anspruch 3 wird die Innenwandung des ringförmigen Behandlungsraumes als Hochfrequenzelektrode eingesetzt, d.h. mit Hochfrequenzpotential beaufschlagt, womit die Aussenfläche auf ein Bezugspotential gelegt werden kann.

Der weiteren bevorzugten Ausführungsvariante nach Anspruch 4 folgend, wird der von der radial inneren Begrenzung des Behandlungsraumes umschlossene Raum für zusätzliche Anlageaggregate ausgenützt, wie für den Drehantrieb für die Trägeranordnung, Pumpen und Pumpanschluss, etc.

Insbesondere bei kontinuierlich entlang des Behandlungsraumes umlaufender Elektrodenanordnung wird optimal homogene Behandlung bei Ausbildung der Anlage nach Anspruch 5 sichergestellt, d. h. durch Vorsehen eines kontinuierlichen Drehantriebes.

Damit wird, beispielsweise und insbesondere bei einem plasmaunterstützten Vakuumprozess, insbesondere einem Plasmapolymerisationsprozess im Behandlungsraum, bei welchem ein oder zwei ringförmige Plasmaentladungsräume gebildet werden, je zwischen der einen Begrenzung des Behandlungsraumes und den Werkstückträgern, eine höchst gleichförmige Behandlung erzielt, beispielsweise wie erwähnt, bei einem plasmaunterstützten chemischen Beschichtungsprozess, bekannt unter dem Kürzel PECVD.

Bei gegebener Achsialausdehnung des Behandlungsraumes wird das zur Verfügung gestellte Volumen bei Vorgehen nach dem Wortlaut von Anspruch 6 optimal genutzt, indem entlang einer Träger-Zylinderfläche eine Vielzahl gleichzeitig zu behandelnder Werkstücke gelagert wird, sei dies, um diese beidseitig gleich, beidseitig unterschiedlich oder auch nur einseitig zu behandeln. Dabei sei darauf hingewiesen, dass je nach elektrischem Betrieb und entsprechender Potentiallegung der Werkstückhalter in ein und demselben Behandlungsraum wahlweise unterschiedliche Behandlungsprozesse gefahren werden können, auch was die ein- oder zweiseitige Behandlung der Werkstücke anbelangt, was z.B. durch Auswechseln von mindestens Teilen der Trägeranordnung und/oder unterschiedliche Potentiallegung erfolgen kann.

Um im weiteren das hinlänglich bekannte Problem der Vakuumprozesskontamination durch Abrieb bei im Prozessraum bewegten Werkstücken zu beheben, wird vorgeschlagen, die Anlage nach dem Wortlaut von Anspruch 10 auszubilden.

Dadurch wird sichergestellt, dass Kontaminationspartikel generell und insbesondere Abriebpartikel, bedingt durch den Trägeranordnungsantrieb die Werkstückbehandlung nur in reduziertem Masse, wenn überhaut, beeinträchtigen können.

Insbesondere, wenn entlang des Behandlungsraumes ein Bebandlungsprozess durchgeführt wird, wie beispielsweise für optische Bauelemente, woran höchste Anforderungen bezüglich Gleichförmigkeit erfüllt werden sollen, wird vorgeschlagen, die Anlage nach einem der Ansprüche 11 oder 12 auszubilden, d.h. die Trägeranordnung im Zentralbereich drehbeweglich zu lagern und vorzugsweise im Peripheriebereich anzutreiben, womit auch bezüglich Bewegungsführung höchstmögliche Gleichförmigkeit und aufgrund des bei Peripherieantriebes erzielten grossen Antriebsradius eine höchst präzise Bewegungsführung möglich wird.

Berücksichtigt man dabei die anzustrebenden relativ grossen Durchmesser des Behandlungsraumringes und die angestrebte Bewegungspräzision, mit welcher die Trägeranordnung im Behandlungsraum zu führen ist, mit exakt vorgegebenen konstanten, radialen Abstandsverhältnissen, und dass auch zu anderen Teilen des Behandlungsraumes genau vorgegebene Abstände bleibend eingehalten werden sollen, insbesondere auch die kleinen Dunkelraumabstände in der Grössenordnung einiger weniger Millimeter, so ist erkenntlich, dass der Drehlagerung der genannten Trägeranordnung grosse Bedeutung zukommt. Deshalb wird vorgeschlagen, nach dem Wortlaut des erwähnten Anspruchs 12 die Trägeranordnung, entweder im Zentralbereich oder im Peripheriebereich axial zu lagern und entsprechend im Peripheriebereich oder im Zentralbereich radial und dabei vorzugsweise den Antriebseingriff auf die Trägeranordnung im Zentralbereich oder im Peripheriebereich, vorzugsweise letzteres, vorzunehmen, dabei den genannten Antriebseingriff gleichzeitig als Teil der erwähnten Lagerung auszunützen.

Durch diese funktionsgetrennte Lagerung wird eine präzise Bewegungsführung ermöglicht, ohne dass konstruktiv höchst aufwendige Vorkehrungen getroffen werden müssten, die grossdurchmessrige Trägeranordnung in sich so auszubilden, dass sie im geforderten Umfange die genannten Anforderungen bleibend erfüllt.

Um dabei sicherzustellen, dass z.B. thermisch bedingte Verformungen der Trägeranordnung zu Ungenauigkeiten in der Bewegungsführung der Werkstücke entlang des Behandlungsraumes führen, wird vorgeschlagen, dem Wortlaut von Anspruch 13 folgend, die Trägeranordnung mit einer Trägerplatte zu versehen, die durch Materialwahl und/oder Ausformungen, insbesondere axial elastisch deformierbar ist, vorzugsweise eine speichenartige Struktur aufweist und weiter vorzugsweise peripher axial gelagert ist.

Durch eine solche Ausbildung der Trägeranordnung, beispielsweise mit elastisch quer zur Trägerebene, d.h. axial elastisch biegbaren Speichen, wird erreicht, dass, insbesondere bei zentraler Radiallagerung, sich die Trägerplatte aufgrund ihrer Elastizität optimal an die peripher vorgesehenen Axialführungen anlegen kann, so dass in diesem Bereich, woran auch zwischen die Wandungsringflächen einragende Partien der Trägeranordnung ansetzen, eine exakte Bewegungsführung gewährleistet ist und auch die oben erwähnten Abstände zu übrigen Teilen des Rezipienten während der Bewegung zeitkonstant eingehalten werden.

Damit wird das Einhalten von Dunkelraumabständen in der Grössenordnung von 3mm auch bei den grossen Durchmessern (≥ 1m) der Trägerplatte ohne grossen Aufwand möglich.

In höchst einfacher Art und Weise wird weiter vorgeschlagen, dem Wortlaut von Anspruch 14 folgend, den Antrieb und insbesondere einen unten gelagerten Peripherieantrieb mittels eines Antriebrades auf die Trägeranordnung zu übertragen.

Dadurch, dass, dem Wortlaut von Anspruch 15 bzw. 17 folgend, die Werkstückhalter - und mithin die darin gehalterten Werkstücke - bezüglich mindestens Teilen der Wandungsringflächen elektrisch isoliert sind, bevorzugterweise bezüglich Teilen beider Wandungsringflächen, wird höchste Flexibilität insofern erreicht, als dass die genannten Ringflächenteile und die Werkstücke je nach beabsichtigtem Behandlungsprozess unabhängig voneinander elektrisch betrieben werden können, je nach Beschaltung, so beispielsweise, dass die genannten Werkstückhalter potentialgleich mit Teilen an den Ringflächen des Behandlungsraumes oder dass Teile and beiden Ringflächen auf gegebenen elektrischen Potentialen betrieben werden, während die Werkstückhalter potentialschwebend betrieben werden, gemäss Anspruch 17 wie insbesondere für RF-Plasmaanwendungen, dabei insbesondere für Plasmapolymerisationsverfahren mit MF oder RF.

Dem Wortlaut von Anspruch 18 folgend, werden in bevorzugter Art und Weise mindestens Teile der Wandungsringflächen und mindestens Teile von Werkstückhaltern als Drei-Elektrodenanordnung elektrisch voneinander unabhängig betreibbar ausgebildet, sind also elektrisch voneinander isoliert montiert.

In einer weiteren bevorzugten Ausführungsvariante, höchst geeignet insbesondere für die Beschichtung optischer Bauelemente, bei welchen höchste Anforderungen an die Gleichförmigkeit der Beschichtung und oft auch an die zweiseitige Beschichtung gestellt werden, wird vorgeschlagen, den erfindungsgemässen Vakuumrezipienten nach dem Wortlaut von Anspruch 16 auszubilden.

Wird bezweckt, zwei ringförmige Plasmaentladungsräume zu schaffen, so zum Beispiel, um an optischen Bauelementen, wie an Linsen, deren eine den Wandungsringflächen je zugekehrte Oberflächen unterschiedlich zu beschichten, so werden mindestens Partien der Trägeranordnung, die zwischen die Wandungsringflächen einragen, metallisch ausgebildet und auf ein Bezugspotential gefesselt oder aber metallisch ausgebildet und potential beaufschlagt und dann die Elektroden an den Wandungsringen auf gleiche oder unterschiedliche Bezugspotentiale gelegt. Sollen die Werkstücke, wie beispielsweise bei RF-Plasmabehandlungen, potentialschwebend betrieben werden, so können die genannten Trägerpartien aus isolierendem Material gebildet sein, wobei in diesem Falle diese einragenden Partien, um keine Abschotung zwischen den Wandungsringfläche zu bilden, so ausgebildet sind, dass ein Entladungsdurchgriff von einer Wandungsringfläche zur anderen möglich ist. Die einragenden Trägerpartien werden dann z.B. gitterartig oder als einzelne einragende Trägerarme ausgebildet.

Es ist es weiter durchaus möglich, entlang des Behandlungsraumes nicht eine homogene, gleichförmige Behandlung vorzunehmen, sondern diskrete Behandlungsstationen vorzusehen, wie Zerstäubungs- und/oder Verdampfungsquellen und/oder Heiz- und/oder Aetz-Stationen.

Durch Ausbildung des erfindungsgemässen Rezipienten nach dem Wortlaut von Anspruch 7 oder 8 wird erreicht, dass bestmögliche Zugänglichkeit in den Ringraum gegeben ist, was sich, wie ohne weiteres ersichtlich, höchst günstig auf die Beschickung, insbesondere eine automatische Beschickung, und die Innenraumreinigung auswirkt.

Die prinzipielle Auslegung des erfindungsgemässen Vakuumrezipienten ermöglicht, eine höchst kompakte Vakuumbehandlungsanlage aufzubauen.

Wie bereits erwähnt wurde, eignet sich der erfindungsgemässe Rezipient bzw. die erfindungsgemässe Vakuumbehandlungsanlage insbesondere für die gleichzeitige Behandlung optischer Bauteile auf zwei Seiten, dem Wortlaut von Anspruch 19 folgend, insbesondere für deren Beschichtung, insbesondere in einem reaktiven, plasmaunterstützten Behandlungsprozess, wobei, dem Wortlaut von Anspruch 20 folgend, sich insbesondere anbietet, den erwähnten erfindungsgemässen Rezipienten bzw. die damit ausgerüstete Vakuumbehandlungsanlage für die gleichzeitige, im wesentlichen gleiche, beidseitige Beschichtung optischer Bauteile einzusetzen, bei welchen, höchste Anforderungen an Gleichförmigkeit der Beschichtung, je einseitig betrachtet, aber oft auch über die zwei sich gegenüberliegenden Seiten betrachtet, wie bei Linsen, gestellt werden.

Die Erfindung wird anschliessend beispielsweise anhand von Figuren erläutert.

### Es zeigen:

- Fig. 1: schematisch, einen Rezipienten an einer Anlage gemäss vorliegender Erfindung,
- Fig. 2a, 2b: an einem Rezipienten gemäss Fig. 1 zwei bevorzugte Werkstückträgeranordnungen, schematisch dargestellt,
- Fig. 3: schematisch, die bevorzugte elektrische Beschaltung von Rezipientenringflächen und Werkstückträgern, mit der Darstellung möglicher Potentiallegungen dieser Teile,
- Fig. 4a, 4b: schematisch, Ausbildungsvarianten der Trägeranordnung gemäss Fig. 2a mit, weiterhin schematisch, der Positionierung von Werkstücken auf bzw. in der Trägeranordnung,
- Fig. 5: schematisch eine bevorzugte Ausbildung von Rezipient mit Trägeranordnung gemäss Fig. 1 bzw. Fig. 2a, b, zur Realisation unterschiedlicher Betriebsarten,
- Fig. 6: schematisch, eine erfindungsgemässe Anlage mit diskreten Behandlungsstationen,
- Fig. 7: schematisch eine weitere Ausführungsvariante des Rezipienten an einer erfindungsgemässen Anlage,
- Fig. 8: schematisch eine Aufsicht auf den Rezipienten von Fig. 7 in zwei unterschiedlichen Ausführungsvarianten, mit Zugangstüren und, als Teil einer Behandlungsanlage, mit Aggregaten bzw. Anschlüssen der Anlage,
- Fig. 9a, 9b: schematisch zwei bevorzugte Varianten der Lagerung eines Werkstückträgers am Rezipienten,
- Fig. 10: schematisch eine bevorzugte Ausführungsvariante eines Antriebs tellers an einer Werkstückträgeranordnung am Rezipienten der erfindungsgemässen Anlage,
- Fig. 11: eine Längsschnittdarstellung durch eine bevorzugte Realisationsform einer erfindungsgemässen Anlage,
- Fig. 12: eine schematische Längsschnittdarstellung durch eine weitere Ausführungsform einer erfindungsgemässen Anlage,
- Fig. 13: eine schematische Längschnittdarstellung durch einen Teil einer weiteren Ausführungsform einer erfindungsgemässen Anlage,
- Fig. 14: schematisch einen Längsschnitt durch einen Teil einer weiteren Ausführungsvariante einer erfindungsgemässen Anlage,
- Fig. 15: schematisch einen Längsschnitt durch einen Teil einer heute bevorzugten Ausführungsvariante einer erfindungsgemässen Anlage.

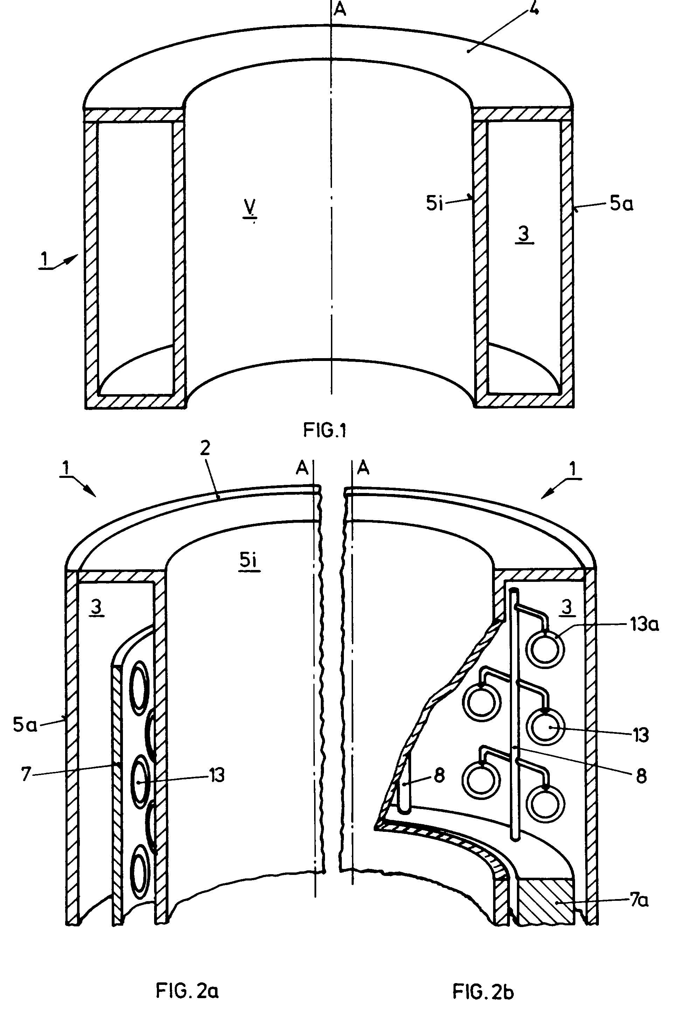

In Fig. 1 ist schematisch der erfindungsgemässe Vakuumrezipient 1 dargestellt. Der Behandlungsraum 3 wird umspannt von einer äusseren Wandungsringfläche 5a und einer inneren 5i. Bevorzugterweise und aus noch zu beschreibenden Gründen ist der Vakuumrezipient 1 mit Wandungen 5a, 5i koaxial zu einer Achse A aufgebaut, welche bevorzugterweise und, wie dargestellt, vertikal steht.

Insbesondere kann das von der inneren Wandungsringfläche 5i umspannte Volumen V für Aggregate einer Vakuumbehandlungsanlage mit dem erfindungsgemässen Vakuumrezipienten genutzt werden.

In Fig. 2a, b sind wiederum schematisch zwei Ausschnitte aus dem erfindungsgemässen Vakuumrezipienten 1 dargestellt, mit zwei bevorzugten, prinzipiellen Trägeranordnungen für Werkstücke, die im Behandlungsraum 3 zu behandeln sind.

Die eine bevorzugte Trägeranordnung, gemäss Fig. 2a, umfasst einen Zylinder 7, welcher, in vorgegebenem Abstand, im Behandlungsraum 3 zwischen innerer und äusserer Wandungsringfläche 5i bzw. 5a angeordnet ist. Der Werkstückträgerzylinder 7 wird vorzugsweise im Behandlungsraum 3 in noch zu erläuternder Art und Weise getrieben, um die Achse A.

Gemäss Fig. 2b umfasst die zweite bevorzugte Trägeranordnung einen Trägerring 7a, woran Trägerarme 8 gelagert sind, welche gemeinsam ebenfalls eine Zylinderfläche aufspannen. An den Trägerarmen 8 sind Werkstücke 13, wie schematisch dargestellt, gehaltert. Auch der Trägerring 7a und damit die Trägerarme 8 und die Werkstücke 13 werden im Ringraum 3 um die Achse A der Ringkammer getrieben gedreht. Die Werkstücke 13 werden sowohl am oder im Trägerzylinder 7, wie auch an den Armen 8 mittels Werkstückhaltern 13a, wie beispielsweise mittels federnder Spangen, gehaltert.

In den erfindungsgemässen Rezipienten 1, insbesondere mit den bevorzugterweise vorgesehenen Trägeranordnungen 7 bzw. 7a, 8, können verschiedenartigste Vakuumbehandlungsverfahren an den Werkstücken 13 durchgeführt werden, wie erwähnt, PVD-Verfahren, CVD-Verfahren und alle Mischformen dieser beiden prinzipiellen Behandlungskategorien sowie Aetzverfahren, generell vakuumoberflächen-Behandlungsverfahren.

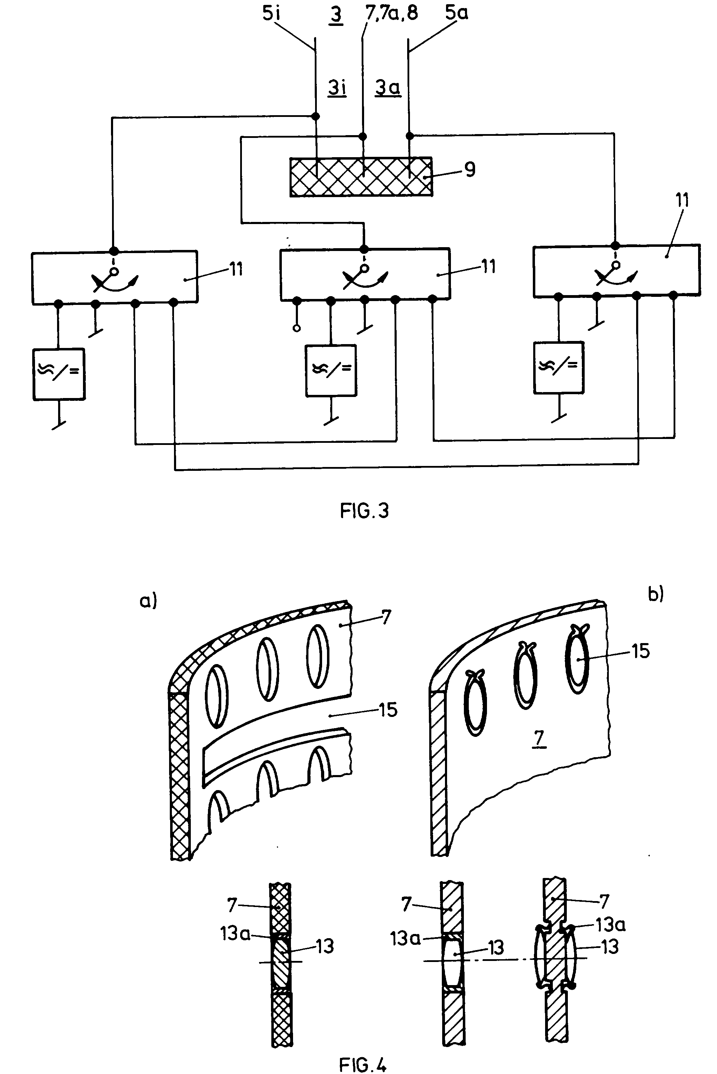

In Fig. 3 sind schematisch die drei Rezipiententeile, Innenwandungsringfläche 5i, Aussenwandungsringfläche 5a und dazwischen einragende Werkstückträgeranordnung 7 bzw. 7a, 8, rein schematisch dargestellt, wobei, wie mit der Isolation 9 veranschaulicht sei, diese drei Teile elektrisch voneinander isoliert sind. Dies ergibt, was, wie nun anhand der weiteren Ausführungen zu Fig. 3 deutlich werden wird, höchstmögliche Flexibilität bezüglich elektrischen Betriebs der drei Teile und damit bezüglich Verwendung des erfindungsgemässen Rezipienten für verschiedenartigste Vakuumbehandlungsverfahren. Jede der drei "Ringflächen", Aussenwandungsringfläche 5a, Innenwandungsringfläche 5i und Werkstückträger, können, prinzipiell als Drei-Elektrodenanordnung, wahlweise elektrisch beschaltet werden. Dies ist in Fig. 3 mit "Möglichkeitswählern" 11 anschaulich gemacht, die weniger als Umschalteinheiten zu verstehen sind als als graphische Darstellung der verschiedenen Möglichkeiten, die genannten Teile relativ zueinander elektrisch zu betreiben.

Wie ersichtlich, kann die Innenwandungsringfläche 5i mit DC- oder AC-Energie gespiesen werden, bis hin in den RF-Bereich oder gar, bei dem Fachmann bekannter, entsprechender Auslegung, in den Mikrowellenbereich. Gleichzeitig kann die Trägeranordnung 7 bzw. 7a, 8 potentialschwebend geschaltet sein und die Aussenwandungsringfläche 5a auf Bezugspotential oder aber die Trägeranordnung 7 bzw. 7a, 8 gemeinsam mit Aussenwandungsringfläche 5a auf Bezugspotential gelegt sein. Es kann dabei auch die Trägeranordnung 7 bzw. 7a, 8 auf Bezugspotential und gleichzeitig die Aussenwandungsringfläche 5a auf DC- oder AC-Potential gelegt werden, wiederum gegebenenfalls bis hin in den Mikrowellenbereich. Im letzterwähnten Fall werden zwei Diodenentladungsräume geschaffen, je zwischen einer der Wandungsringflächen und der Trägeranordnung, die gleich oder unterschiedlich betreibbar sind. Bei schwebend betriebener Trägeranordnung oder auf Bias gelegter liegt er innerhalb des einen zwischen den Wandungsringflächen 5a bzw. 5i gebildeten Entladungsraumes. Von den erwähnten Möglichkeiten ausgehend, erkennt nun der Fachmann ohne weiteres die möglichen Kombinationen, wie die erwähnten Teile, je nach Einsatzzweck des erfindungsgemässen Rezipienten, flexibel elektrisch beschaltet werden können.

In den Fig. 4a und 4b sind, schematisch, unterschiedliche Ausbildungsformen des Werkstückträgerzylinders 7 gemäss Fig. 2a dargestellt, als eine der bevorzugten Varianten der Trägeranordnung 7, 7a, 8.

Gemäss Fig. 4a besteht er im wesentlichen aus isolierendem Material für den Betrieb des Behandlungsraumes 3 gemäss Fig. 3 als ein Entladungsstreckenraum. Wie in Fig. 4a unten schematisch dargestellt, sind Werkstücke 13, beispielsweise optische Linsen aus einem Kunststoff, von beiden Seiten zugänglich mittels Haltespangen 13a im Kunststoffträgerzylinder 7 gelagert, wobei, wie aus Fig. 4a ersichtlich, massgebliche Partien 15 des Zylinders 7 ausgenommen sind, um den Durchgriff der zwischen den Wandungsringen 5i und 5a aufgebauten Entladung zu ermöglichen, was bei Aufbau der Anordnung 7a, 8 gemäss Fig. 2b ohnehin gegeben ist. Gemäss Fig. 4b bestehen mindestens wesentliche Partien des Trägerzylinders 7 aus elektrisch leitendem Material. Damit ist die Möglichkeit geschaffen, diesen Zylinder bzw. die daran oder darauf gehalterten Werkstücke 13 auf beliebiges Potential zu legen und damit den Behandlungsraum 3 als Zweikammernraum zu betreiben oder als Einkammernraum zwischen den Ringen 5i und 5a und auf Bias-gelegten Werkstücken 13 oder gegebenenfalls auch als Einkammernraum zwischen einem der Ringe 5i oder 5a und auf Bezugspotential gelegten Werkstückträgerzylinder 7 für die einseitige Behandlung von Werkstücken. Bezüglich Werkstoffwahl (isolierend, leitend) und elektrischer Betriebsmöglichkeiten gilt für die zweite bevorzugte Ausbildung der Trägeranordnung nach Fig. 2b Entsprechendes.

Wie in Fig. 4b unten dargestellt, ergibt sich bei leitendem Zylinder 7 die Möglichkeit, die Werkstücke 13 beidseitig zugänglich und behandelbar im Trägerzylinder 7 anzuordnen, dabei die beidseitige Beschichtung in zwei getrennt betriebenen Behandlungsteilräumen gemäss Fig. 3, 3i und 3a zu behandeln oder, bei potentialschwebend-geschaltetem Trägerzylinder 7, eine zweiseitige Behandlung der Werkstücke 13 in einem einheitlichen Behandlungsraum 3 gemäss Fig. 3 vorzunehmen. Ebenfalls ist die Möglichkeit geschaffen, Werkstücke 13 auf den Trägerzylinder 7 aufzulegen und je in den Behandlungsräumen 3i und 3a gemäss Fig. 3 die doppelte Anzahl Werkstücke gleichzeitig und einseitig zu behandeln. Auch dies kann bei der Anordnung von Trägerarmen 8 gemäss Fig. 2b realisiert werden, indem die stabilen Halterungen 13a auch ein- oder zweiseitige Zugänglichkeit der Werkstückoberflächen gewährleisten können.

Wie sich dem Fachmann nun ohne weiteres ergibt, sind im Rahmen des fachmännischen Könnens praktisch keine Grenzen gesetzt, bekannte Behandlungsverfahren, bei entsprechender elektrischer Beschaltung und entsprechender Auslegung der Trägeranordnung 7 bzw. 7a, 8 mit dem erfindungsgemässen Rezipienten auszuführen. Er lässt sich frei wählbar als Doppeldioden-, Einfachdioden- oder Triodenanordnung betreiben, als Doppeldiodenanordnung, insbesondere für zweiseitige, gleiche oder unterschiedliche Plasmapolymerisation.

Im weiteren kann die Trägeranordnung mit anderen Behandlungsquellen als Bias-Anordnung für die Werkstücke betrieben werden.

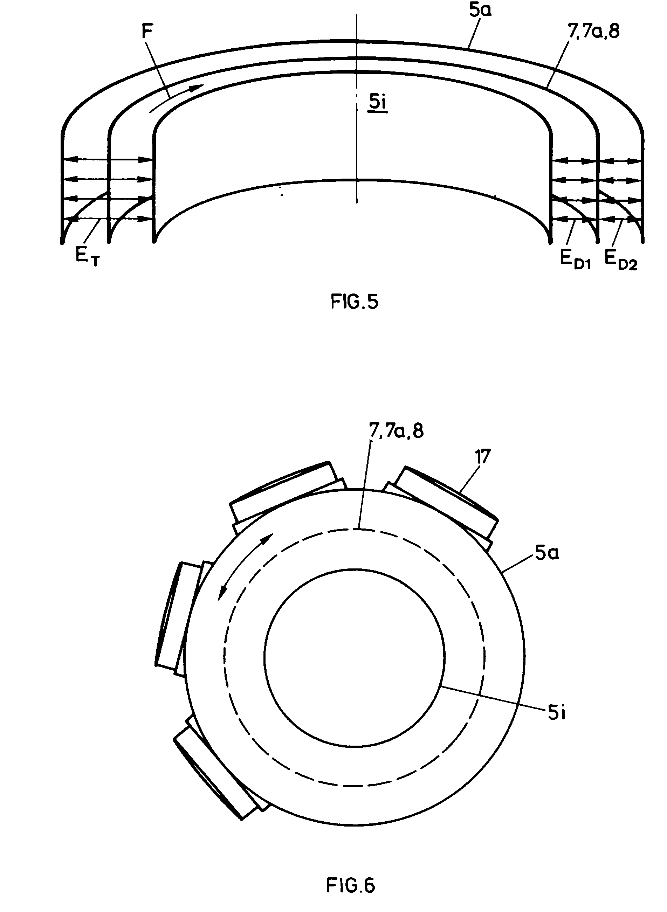

In Fig. 5 ist, wiederum schematisch, eine bevorzugte Ausführungsform dargestellt, bei welcher mindestens wesentliche Partien von Aussen- und Innenwandungsringflächen 5a bzw. 5i und der Trägeranordnung 7 bzw. 7a, 8 umlaufend gleichförmig als Elektrodenanordnungen in der erwähnten Dioden- oder Trioden-Beschaltungen wirken. Links ist, schematisch, der Entladungsraum E_{T} bei Triodenbeschaltung dargestellt, rechts die beiden Entladungsräume E_{D1}, E_{D2} bei Doppeldiodenbeschaltung.

Wie bereits eingangs erwähnt wurde, wird zur Erzielung höchster Behandlungshomogenität, wie mit dem Pfeil F in Fig. 5 dargestellt, die Trägeranordnung 7 bzw. 7a, 8 zwischen den Wandungsringflächen drehbewegt. Dies ergibt nun gemäss Fig. 6 auch die Möglichkeit, an der Innen- oder Aussenwandungsringfläche, hier schematisch an der Aussenwandungsringfläche 5a dargestellt, diskrete Behandlungsstationen 17 zu montieren, wie Sputter-Quellen, Heizquellen, Aetzquellen, Bogenverdampfungsquellen, Elektrodenstrahl-Verdampfungsquellen etc. Wird bei Ausbildung des erfindungsgemässen Rezipienten prinzipiell gemäss Fig. 5 die Werkstückträgeranordnung, zur Erlangung höchstmöglicher Behandlungsgleichförmigkeit, kontinuierlich angetrieben, so wird es bei Ausbildung nach Fig. 6 vorzugsweise intermittierend, d.h. in Schritten betrieben, so dass die auf bzw. an der Werkstückträgeranordnung 7 bzw. 7a, 8 gehalterten Werkstücke sequentiell von Behandlungsstation zu Behandlungsstation gefördert werden.

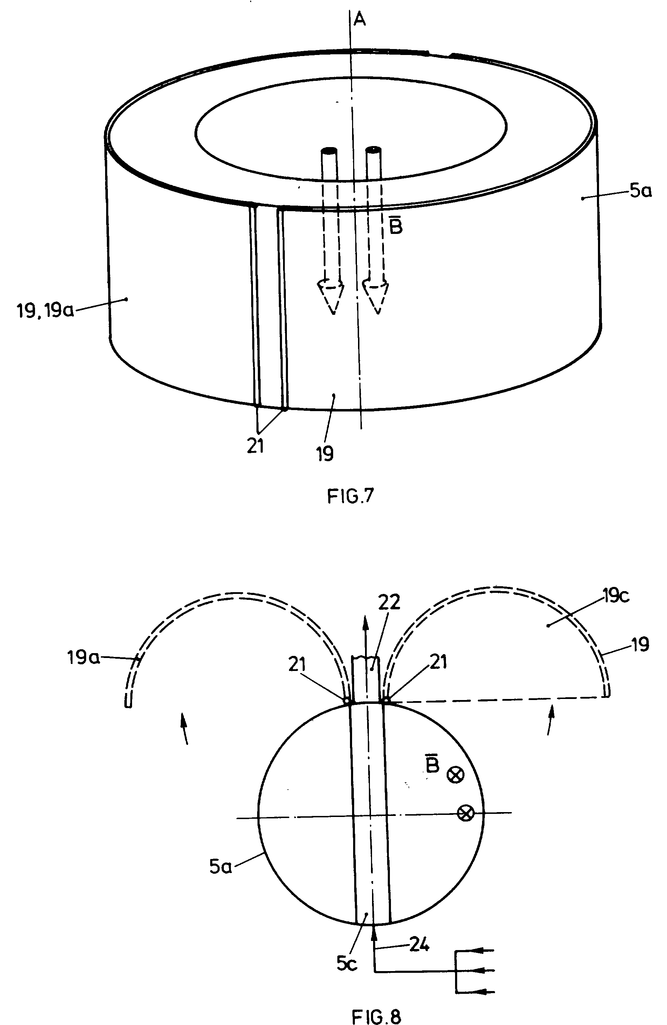

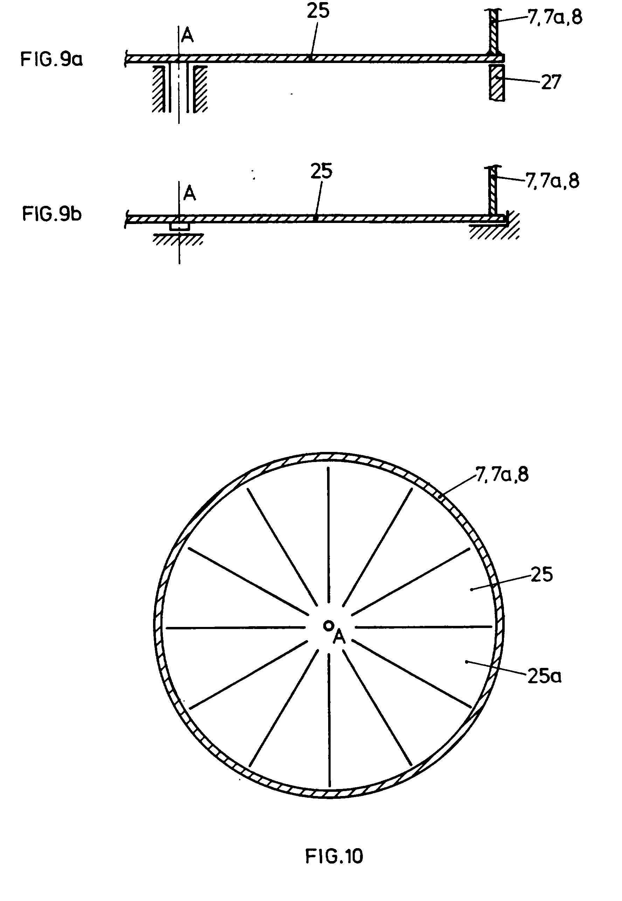

In den Fig. 7 und 8 ist ein wesentlicher Aspekt des erfindungsgemässen Rezipienten dargestellt, nämlich den ringförmigen Behandlungsraum grossflächig öffnen zu können, um ihn mit der Mehrzahl Werkstücke 13 zu chargieren bzw. zu dechargieren. Demnach umfasst in einer ersten bevorzugten Ausführungsvariante die Aussenwandungsringfläche 5a mindestens eine Türschale 19, welche parallel zur Ringachse A an Schwenklagern 21 schwenkgelagert ist, wie dargestellt vorzugsweise zwei derartige Türschalen 19. Damit wird ermöglicht, dass der Behandlungsraum 3 in optimaler Art und Weise zugänglich wird, sei dies, um den vorgesehenen Werkstückträger zu beschicken oder zu entladen oder um den Behandlungsraum zu reinigen.

Wie in Aufsicht aus Fig. 8 ersichtlich, können die vorzugsweise zwei vorgesehenen Türschalen 19, wie dies bei 19a dargestellt ist, ausschliesslich als Schalen der äusseren Ringfläche 5a ausgebildet sein oder, wie rechts mit 19 bezeichnet, mindestens teilweise wannenartig, einen Bodenteil 19c des Rezipienten mitumfassen. Zwischen den beiden, wie auch immer ausgebildeten Türschalen 19 bzw. 19a bleibt ein relativ schmaler Mittensteg der äusseren Ringfläche 5a stationär, woran, wie aus Fig. 8 ersichtlich, Aggregate der Anlage, so beispielsweise ein Pumpanschluss 22 für den Innenraum oder Gasanschlüsse 24 für Arbeits- oder Reaktivgas, montiert sind.

In Fig. 9a ist schematisch eine erste bevorzugte Ausführungsvariante der Drehlagerung der Werkstückträgeranordnung dargestellt. Die Trägeranordnung umfasst einen Trägerteller 25, woran der vorbeschriebene Zylinder, sei dies durch einen Trägerzylinder 7 selbst gemäss Fig. 2a oder diskrete Trägerarme 8 gemäss Fig. 2b aufgespannt, peripher, gegebenenfalls auswechselbar gelagert ist. Der Trägerteller 25 ist gemäss Fig. 9a in seinem Zentralbereich um die Innenraumachse A radial gelagert und in seinem Peripheriebereich axial abgestützt bzw. gelagert, wobei bevorzugterweise die periphere Axiallagerung mindestens zum Teil durch einen Antriebseingriff auf den Teller 25 gebildet ist, wozu die axiale Abstützung 27 ein Antriebsrad (nicht dargestellt) umfasst.

In Fig. 9b sind die Funktionen von Zentral- und Peripherlagerung bezüglich Fig. 9a vertauscht, indem hier der Trägerteller 25 in seinem Zentralbereich axial abgestützt ist und peripher radial gelagert ist. Durch die in den Fig. 9 dargestellte bevorzugte Trennung von Radiallagerung und Axiallagerung wird erreicht, dass die in vielen Fällen grossdurchmessrige Trägerscheibe 25, statisch bestimmt, höchst exakt bewegt wird, ohne dass sich, beispielsweise bei Tellerdurchmessern ≥ 1m, z.B. temperaturbedingte Tellerverzüge auf die exakte Bewegungsführung der Trägeranordnungspartien entsprechend 7, 7a oder 8 auswirken würden. Auf diese Art und Weise werden aufwendige konstruktive Vorkehrungen am Trägerteller 25 selbst, zur Sicherstellung der genannten Präzision auch unter Betriebsverhältnissen, umgangen.

In Fig. 10 ist schematisch in Aufsicht der erwähnte Trägerteller 25 dargestellt. Zur Behebung allfälliger Verzüge, wie unter Betriebstemperaturen, wird der Teller 25 vorzugsweise weiter so ausgebildet, dass er in Axialrichtung A elastisch verformbar ist. Damit wird in seinem Peripheriebereich, beispielsweise betrachtet im Zusammenhang mit Fig. 9a, erreicht, dass er durch sein Eigengewicht und dasjenige der aufragenden Werkstückträgeranordnungsteile 7 etc. permanent bündig auf das Axiallager 27 bzw. die dieses Lager bildenden Organe gedrückt wird. Hierzu umfasst der Trägerteller 25 bevorzugterweise eine speichenartige Struktur mit Speichen 25a, welche, gepaart mit entsprechender Wahl eines elastischen Materials, mindestens für Teile des Tellers, und/oder deren entsprechende Dickendimensionierung, die obgenannte Auflage sichergestellt wird, wobei gleichzeitig auch kleine Dunkelraumabstände von z.B. 3mm zwischen Tellerfläche und benachbarten, stationären Rezipiententeilen eingehalten werden, indem ein mechanisches Wobbeln des Tellers vermieden wird.

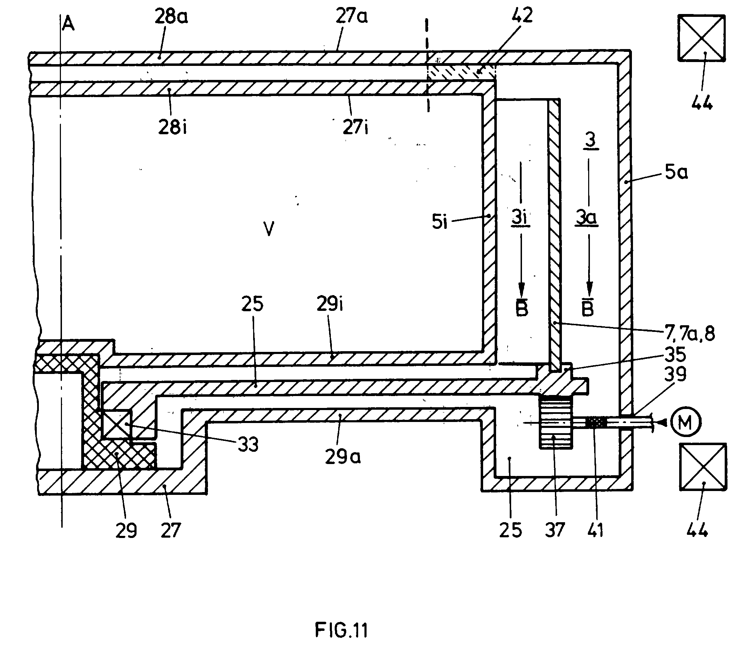

In Fig. 11 ist schematisch eine bevorzugte Ausführungsvariante des erfindungsgemässen Rezipienten dargestellt. Es sind den bis anhin prinzipiell erläuterten Teilen dieselben Positionsziffern zugeordnet. Der ringförmige Behandlungsraum 3, unterteilt in die Behandlungsräume 3i und 3a, ist radial begrenzt durch die Innenwandungsringfläche 5i und die Aussenwandungsringfläche 5a. Die Ringflächen 5i und 5a werden durch je eine koaxiale Kammer 27i bzw. 27a gebildet, wobei die innere Kammer 27i über eine elektrische Isolation 29 von der äusseren 27a getrennt ist. Während obere Abschlussplatten 28i bzw. 28a der beiden Kammern auf Dunkelraumabstand gehalten sind, liegt zwischen den unteren Abschlussplatten 29i und 29a der genannten Kammer die Trägerplatte 25. Sie ist zentral durch Radiallager 33 drehgelagert und weist zu den benachbarten unteren Abschlussplatten 29i bzw. 29a je Dunkelraumabstand auf. An ihrer Peripherie trägt sie gemäss Fig. 2a oder 2b ausgebildete Werkstückträgeranordnungen 7 bzw. 7a, 8, bevorzugterweise auswechselbar, und ruht auf Axiallagern, dabei insbesondere auf einem Antriebsrad 37, welches durch einen Motor M und über eine dynamische Vakuumdichtung 39 angetrieben wird und das, wie schematisch bei 41 dargestellt ist, bezüglich Motor und Ringfläche 5a elektrisch isoliert ist oder selbst aus isolierendem Material besteht. Selbstverständlich sind vorzugsweise entlang der Peripherie des Trägerrades 25 weitere axiale Abstützflächen vorgesehen, wie beispielsweise Laufrollen. Der Trägerteller 25 wird bevorzugterweise ausgebildet, wie anhand von Fig. 10 erläutert wurde. Mit dem Motor M wird die gesamte Werkstückträgeranordnung kontinuierlich, oder falls diskrete Behandlungsstationen gemäss Fig. 6 vorgesehen sind, in Schritten getrieben.

Wie anhand von Fig. 7 bzw. 8 dargestellt wurde, umfasst der bevorzugte Rezipient, hier nicht dargestellt, zwei Türschalen an der äusseren Wandungsringfläche 5a. Soll das zentrale Volumen V für Anlageaggregate genutzt werden, so werden die oberen Abschlussplatten 28a bzw. 28i weggelassen, und an deren Statt werden die oberen Abschlüsse der Wandungsringflächen 5i bzw. 5a isoliert und vakuumdicht verbunden.

Im weiteren werden bevorzugterweise Helmholzspulen 44 vorgesehen, um im Behandlungsraum 3 ein im wesentlichen zur Achse A paralleles Magnetfeld B zu erzeugen, sofern ein solches Magnetfeld beim mit dem Rezipienten durchgeführten Behandlungsprozess erfordert ist. Das resultierende Magnetfeld B ist auch in den Fig. 7 und 8 in einer der möglichen Polaritäten eingetragen.

Es muss betont werden, dass der Werkstückträgerzylinder 7 bzw. Werkstückträger-Armstrukturen nicht zwingend, wie dargestellt, symmetrisch zwischen Innen- und Aussenwandungsringflächen angeordnet werden muss, sondern je nach beabsichtigter Behandlung auch näher an der einen der beiden Wandungsringflächen liegen kann. Durch die hohe Bewegungspräzision, insbesondere der Peripherie des Trägertellers 25, unter Einhaltung der Dunkelraumabstände zu den unteren Abschlussplatten 29a bzw. 29i, ergibt sich, dass mit entsprechend hoher Präzision die Werkstücke in gegebenem Abstand von den Ringflächen bewegt werden, die als Elektrodenflächen, je nach dem beabsichtigten Behandlungsverfahren, elektrisch betrieben werden, gemäss Fig. 3. In Fig. 11 nicht eingetragen sind die elektrischen Beschaltungen, insbesondere der Ringflächen 5i bzw. 5a und des Werkstückträgers 7 bzw. 7a, 8, die jedoch alle drei voneinander isoliert sind, so dass eine der vorerläuterten Beschaltungsart vorgenommen werden kann.

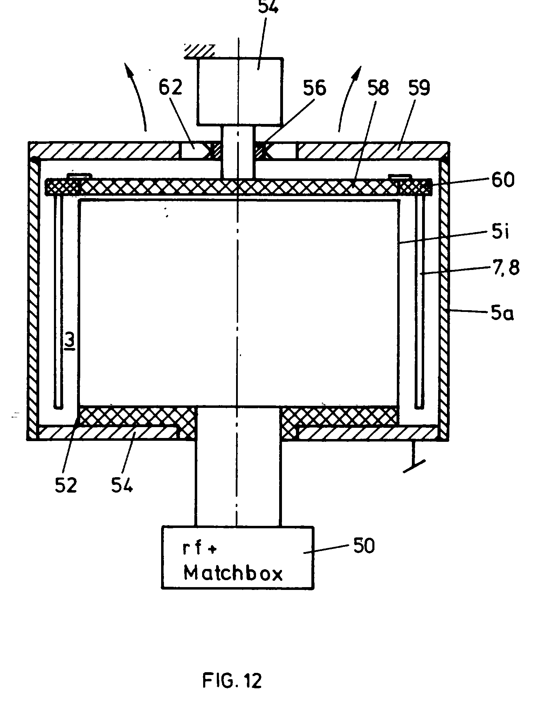

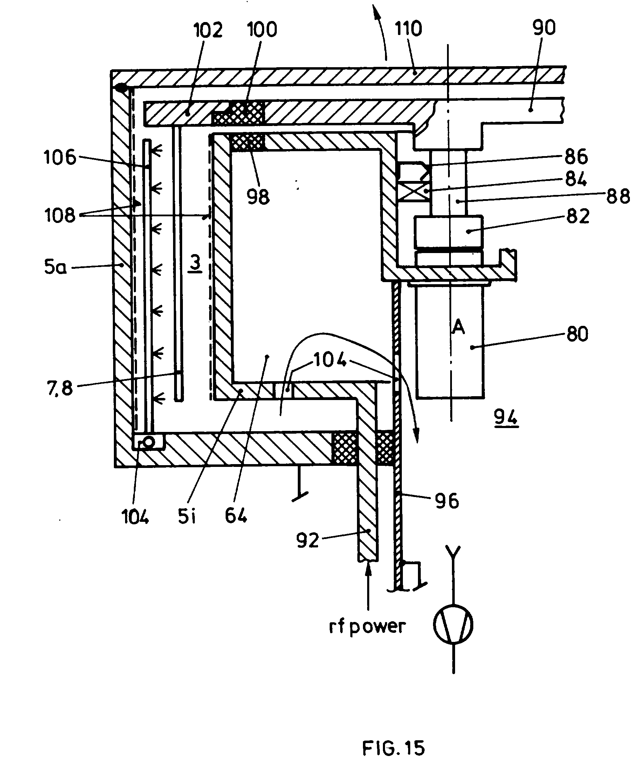

In den Fig. 12 bis 15 sind schematisch weitere Ausführungsvarianten der erfindungsgemässen Behandlungsanlage dargestellt, wobei Fig. 15, wie erwähnt, schematisch, eine der heute bevorzugten Konfigurationen darstellt.

Gemäss Fig. 12 bildet die innere Wandungsringfläche 5i die über ein Anpassnetzwerk an einen Hochfrequenzgenerator, in der Einheit 50 dargestellt, angeschlossene HF-Elektrode. Die äussere Wandungsringfläche 5a bildet die hier beispielsweise auf Massepotential gelegte Gegenelektrode. Die die Hochfrequenzelektrode bildende Wandungsringfläche 5i ist, wie bei 52 dargestellt, von der mit der äusseren Wandungsringfläche 5a auf gleichem Potential betriebenen Bodenfläche 54 des Rezipienten elektrisch isoliert. Mittels eines Motors 54, der bezüglich der Rezipientenaussenwandung mit dem Wandungsaussenring 5a an einem Montageflansch 56 ortsfest montiert ist, wird der Trägerteller 58 vorzugsweise kontinuierlich drehgetrieben. Der Trägerteller 58 ist vorzugsweise aus dielektrischem Material gefertigt.

Am Trägerteller 58 ist ein äusserer Ring 60 entfernbar eingelegt, woran die vorbeschriebenen Träger 7 bzw. 8 hängen. Zur Chargierung des Behandlungsringraumes 3 werden Deckel 59, wie mit den Pfeilen schematisch dargestellt, abgehoben, welche bezüglich des Montageflansches 56 mit Dichtungen 62 in geschlossenem Zustand abgedichtet sind, und es wird der äussere Ring 60 mit der Charge auf den Teller 58 aufgelegt.

Wie ersichtlich, erlaubt auch diese Konfiguration einen Behandlungsraum 3 mit optimal wenig Toträumen zu schaffen, was betreffs Reinhaltung des Behandlungsraumes wesentlich ist. Der Behandlungsraum 3 ist weiter einfach zugänglich und es ist lediglich eine Wellendichtung für die Motorwelle am Montageflansch 56 notwendig. Wiewohl gemäss der Darstellung von Fig. 12 die Werkstücke auf Schwebepotential im Behandlungsraum 3 gehaltert sind, ist es durchaus möglich, an die Werkstücke, gezielt, ein Bias-Potential zu legen.

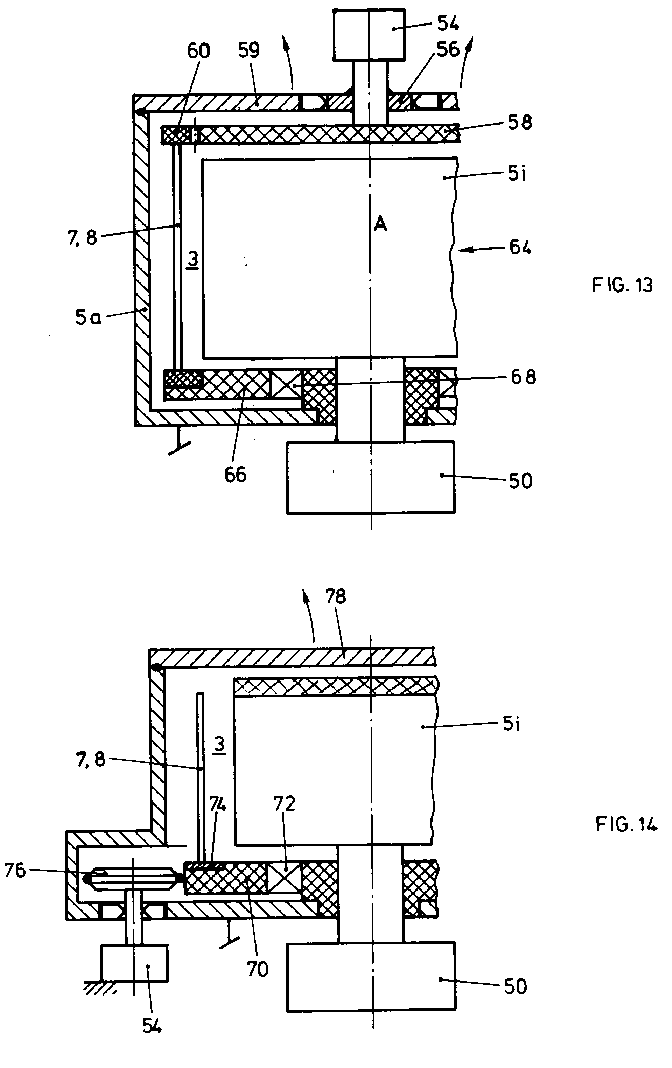

Gemäss Fig. 13 bildet der innere Wandungsring 5i des Behandlungsraumes 3 wiederum die HF-Elektrode. Der äussere Wandungsring 5a ist oben wiederum durch entfernbare Deckel 58 abgeschlossen. Der im Montageflansch 56 gehalterte Motor 54 wirkt auf den Trägerteller 58 aus vorzugsweise dielektrischem Material, an welchem, peripher, der Ring 60 azimutal in Eingriff steht. Axial, d.h. in Richtung der Behandlungsraumachse A, stützen sich hier die Träger 7, 8 auf einer unteren Trägerplatte 66 ab, welche, achsial fest, an Lagern, beispielsweise Kugellagern 68 bezüglich der HF-Durchführung zur HF-Elektrode, entsprechend dem inneren Wandungsring 5i, drehbeweglich gelagert ist. Auch hier sind die sich unmittelbar in der Nähe der mit HF-beaufschlagten Flächen des durch die innere Wandungsfläche 5i bildenden Kerns 64 des Rezipienten gebogenen Flächen der drehgetriebenen Trägeranordnung, vorzugsweise aus dielektrischem Material gefertigt. Der Antrieb über Motor 54 erfolgt über den Teller 58 azimutal auf den Ring 60, überträgt sich über die Träger 7, 8 auf den unteren Teller 66, worauf sich die Träger axial abstützen. Auch hier kann zum Chargieren der Anlage nach Entfernen der Deckel 59 die Substratträgeranordnung bereits chargiert, als Ganzes in den Behandlungsraum 3 eingebracht bzw. daraus entfernt werden.

Bei der Ausführungsvariante nach Fig. 14 bildet die innere Wandungsfläche 5i wiederum HF-Elektrode und ist hierzu mit dem Anpassungsnetzwerk und dem HF-Generator in der Einheit 50 verbunden. Auf einem unteren Trägerteller 70, drehbeweglich an Lagern 72 und axial fest gelagert, stehen die Trägeranordnungen bzw. steht die Trägeranordnung 7, 8, wie schematisch dargestellt, auf einem Sockelring 74. Der Teller 70 wird durch den Antriebsmotor 74 und Reibrad 76 getrieben. Der Behandlungsraum 3 wird von einem, wie mit dem Pfeil angedeutet, entfernbaren Deckel 78 abgeschlossen, nach dessen Oeffnen die Trägeranordnung 7, 8 mit dem Ring 74, vorzugsweise als Ganzes, aus dem Behandlungsraum 3 entfernt werden kann.

In Fig. 15 ist eine heute bevorzugte Ausführungsvariante der Anlage für Hochfrequenz-Plasmabehandlung dargestellt. Zentrisch zur Achse A des auch hier ringförmigen Behandlungsraumes 3 ist der Antriebsmotor 80 für die Trägeranordnung vorgesehen, welche über eine Kupplung 82, eine in Lagern 84 und Dichtungen 86 gelagerte Welle 88 auf den Trägerteller 90 wirkt. Motor und Tellerantrieb sind innerhalb des inneren Wandungsringes 5i des Behandlungsraumes 3 montiert. Der Wandungsring 5i ist, als HF-Elektrode, über eine Durchführung 92 mit einem Anpassungsnetzwerk und dem Hochfrequenzgenerator (nicht dargestellt) verbunden.

Der Zentralraum 94 der Anordnung, mit dem Motor 80, den Zuleitungen hierzu etc. ist mittels eines Schirmzylinders 96 abgeschirmt, der auf dasselbe Potential gelegt ist, wie die als Elektrode wirkende Aussenwandungsfläche 5a. Der zentrale, obere Teil des den Wandungsinnenring 5i mittragenden Kernes 64 des Rezipienten ist, wie bei 98 dargestellt, elektrisch vom hochfrequenzbeaufschlagten äusseren Teil mit der Wandungsfläche 5i und als Ganzes über den Schirmzylinder 96 auf Bezugspotential gelegt.

An der Peripherie des Trägertellers 90 stützt sich, von dessen Zentralteil, wie bei 100 dargestellt, elektrisch isoliert, ein Trägerring 102 ab, woran die Trägeranordnung 7, 8 hängt bzw, die Trägerranordnungen hängen. Die äussere Wandung mit dem äusseren Wandungsring 5a des Behandlungsraumes 3 trägt Leitungen eines Gasverteilsystems 104 mit, wie beispielsweise dargestellt, aufragenden Gasausdüsstäben 106 für den Einlass eines Reaktivgases in den Behandlungsraum 3. Insbesondere für die zweiseitige und gleichzeitige Beschichtung von Werkstücken, wie insbesondere durch Plasmapolymerisation, wird Reaktivgas, vorzugsweise beidseitig der Trägeranordnung 7, 8, in den Behandlungsringraum 3 eingelassen.

Auch Pumpanschlüsse zum Abpumpen des Behandlungsraumes 3 werden vorzugsweise zentral, d.h. koaxial zur Achse A vorgesehen, und das Abpumpen des Behandlungsraumes 3 durch entsprechend bemessene Oeffnungen 104 vorgenommen. Die Chargierung des Behandlungsraumes 3 erfolgt über einen entfernbaren Deckel 110, wie bereits beschrieben oder über eine oder zwei Schwenktüren, wie anhand von Fig. 7, 8 erläutert wurde. Wesentlich an der zuletzt gezeigten Anlagenkonfiguration ist u.a. die Ausnützung des vom inneren Wandungsring 5i umgebenen Zentralteils für Pumpanschlüsse und Drehantrieb der Trägeranordnung. Bei allen vorgestellten Konfigurationen wird, wie dem Fachmann bekannt, gegebenenfalls ein Magnetfeld axial im Behandlungsraum 3 erzeugt, wie anhand von Fig. 11 mit den Spulen 44 zusätzlich gegebenenfalls mittels entsprechend angeordneter Polschuhe und/oder Permanentmagnete.

Im weiteren ist selbstverständlich, dass, wie in Fig. 15 gestrichelt dargestellt, der Behandlungsraum 3 bzw. Innen- und Aussenringflächen 5i, 5a mit entfernbaren Blechen 108 verkleidet werden, die zur Reinigung leicht aus dem Raum 3 entfernbar sind. Bei der heute realisierten Anlage, im wesentlichen nach Fig. 15, zusätzlich mit Spulen 44 nach Fig. 11 versehen, beträgt der Durchmesser des Behandlungsraumes mehr als 1m, die radiale Breite des Behandlungsraumes liegt im Bereich einiger weniger cm, so z.B. von ca. 7cm.

## Patentansprüche

1. Vakuumbehandlungsanlage für Werkstücke mit einem aussen zylindrischen Behandlungsraum (3) und einer drehbaren Trägeranordnung (7, 7a, 8) für eine Mehrzahl von werkstücken (13) im Behandlungsraum (3), die mit einem Drehantrieb verbunden ist, wobei die Behandlungsraumwandung grossflächig öffenbar ist, zur Beladung bzw. Entladung des Behandlungsraumes (3) mit den Werkstücken (13), dadurch gekennzeichnet, dass der Behandlungsraum (3) durch zwei im wesentlichen zylindrische und zueinander koaxiale Wandungsflächen (5a, 5i) begrenzt ist und die Trägeranordnung (7, 7a, 8) zwischen die Wandungsflächen einragt.

2. Anlage nach Anspruch 1, dadurch gekennzeichnet, dass der Behandlungsraum (3) an seiner radialen Innen- und/oder Aussenfläche als ringförmig umlaufende Elektrode zur Erzeugung einer Plasmaentladung im Behandlungsraum (3) ausgebildet ist.

3. Anlage nach einem der Ansprüche 1 oder 2, dadurch gekennzeichnet, dass die koaxiale Innenwandung (5i) des Behandlungsraumes (3) mit einem Hochfrequenzgenerator (50) zur Erzeugung einer Hochfrequenz-Plasmaentladung gekoppelt ist.

4. Anlage nach einem der Ansprüche 1 bis 3, dadurch gekennzeichnet, dass radial innerhalb der inneren Wandungsfläche (5i) zusätzliche Anlageaggregate, wie insbesondere ein Drehantrieb (80) für die Trägeranordnung und/oder ein Pumpanschluss, vorgesehen sind.

5. Anlage nach einem der Ansprüche 1 bis 4, dadurch gekennzeichnet, dass die Trägeranordnung mit einem kontinuierlichen Drehantrieb verbunden ist.

6. Anlage nach einem der Ansprüche 1 bis 5, dadurch gekennzeichnet, dass die Trägeranordnung (7, 7a, 8) eine Zylinderfläche aufspannt, woran Werkstückhalter (13a) verteilt angeordnet sind.

7. Anlage nach einem der Ansprüche 1 bis 6, dadurch gekennzeichnet, dass die radial aussere Wandungsfläche (5a) grossflächig (2) zur Beladung bzw. Entladung des Behandlungsraumes (3) öffenbar ist.

8. Anlage nach einem der Ansprüche 1 bis 7, dadurch gekennzeichnet, dass mindestens eine stirnflächige Abschlusspartie (4) des Behandlungsraumes (3) zur Beladung bzw. Entladung des Behandlungsraumes (3) öffenbar ist.

9. Anlage nach einem der Ansprüche 1 bis 8, dadurch gekennzeichnet, dass die Trägeranordnung mittels diskreter, im wesentlichen zur Achse (A) der koaxialen Wandungsflächen paralleler Träger (8) für ein oder mehrere Werkstücke (13) eine Zylinderfläche aufspannt oder mittels eines Trägerzylinders (7).

10. Anlage nach einem der Ansprüche 1 bis 9, dadurch gekennzeichnet, dass der Behandlungsraum (3) im wesentlichen mit Vertikalachse (A) angeordnet ist, und Drehlager für die Trägeranordnung (7, 7a, 8) bezüglich des Behandlungsraumes (3) unten vorgesehen sind, vorzugsweise auch der Eingriff eines Antriebes auf die Trägeranordnung.

11. Anlage nach einem der Ansprüche 1 bis 10, dadurch gekennzeichnet, dass die Trägeranordnung (7, 7a, 8) zentrisch drehbeweglich gelagert ist und vorzugsweise im Peripheriebereich angetrieben ist.

12. Anlage nach einem der Ansprüche 1 bis 11, dadurch gekennzeichnet, dass die Trägeranordnung zentrisch radial gelagert ist und peripher axial oder umgekehrt, und dass vorzugsweise ein Antriebseingriff auf die Trägeranordnung zentrisch oder peripher vorgesehen ist und dann vorzugsweise mindestens Teil einer der genannten Lagerungen bildet.

13. Anlage nach einem der Ansprüche 1 bis 12, dadurch gekennzeichnet, dass die Trägeranordnung eine drehgelagerte Trägerplatte (25) umfasst, die durch Materialwahl und/oder Ausformungen elastisch deformierbar ist, vorzugsweise eine speichenartige Struktur aufweist und die vorzugsweise peripher in Richtung der Achse (A) des Behandlungsraumes abgestützt ist.

14. Anlage nach einem der Ansprüche 1 bis 13, dadurch gekennzeichnet, dass ein Antriebsmotor für die Trägeranordnung über ein Antriebsrad (37) auf die Trägeranordnung einwirkt.

15. Anlage nach einem der Ansprüche 1 bis 14, dadurch gekennzeichnet, dass Werkstückhalter an der Trägeranordnung elektrisch isoliert von übrigen Anlageteilen montiert sind und gegebenenfalls gezielt auf ein elektrisches Potential gelegt sind.

16. Anlage nach einem der Ansprüche 1 bis 15, dadurch gekennzeichnet, dass Werkstückhalter (13a) an der Trägeranordnung im wesentlichen aequidistant zwischen den Wandungsflächen (3) bewegt werden.

17. Anlage nach einem der Ansprüche 1 bis 16, dadurch gekennzeichnet, dass Werkstückhalter (13a) an der Trägeranordnung potentialschwebend betrieben werden.

18. Anlage nach einem der Ansprüche 1 bis 17, dadurch gekennzeichnet, dass mindestens Teile der äusseren und/oder inneren Wandung (5a, 5i) des ringförmigen Behandlungsraumes (3) und mindestens Teile von Werkstückhaltern (13a) als Drei-Elektrodenanordnung elektrisch unabhängig voneinander betreibbar sind.

19. Verwendung der Anlage nach einem der Ansprüche 1 bis 18 für die gleichzeitige Behandlung optischer Bauteile auf zwei Seiten, insbesondere für deren Beschichtung.

20. Verwendung nach Anspruch 19 für die gleichzeitige, im wesentlichen gleiche Beschichtung optischer Bauteile auf zwei Seiten.

21. Verwendung nach einem der Ansprüche 19 oder 20 für die Beschichtung optischer Bauteile mittels Plasmapolimerisation.

## Claims

1. Vacuum treatment apparatus for workpieces comprising a on the outside annular treatment chamber (3) and rotatable carrier means (7,7a,8) for a multitude of workpieces (13) in the treatment chamber (3), which are linked with rotating drive means, and wherein one substantial part of the wall of said treatment chamber may be opened for charging and discharging the treatment chamber (3) with said workpieces (13), characterised in that said treatment chamber (3) is delimited by two substantially cylindrically and mutual coaxial wall portions (5a, 5i) and the carrier means (7,7a,8) are projecting in between said wall surfaces.

2. Apparatus according to claim 1, characterised in that the treatment chamber (3) comprises along its radial inner and/or outer wall surface an annular surrounding electrode surface for the generation of a plasma discharge in said treatment chamber (3).

3. Apparatus according to claim 1 or 2, characterised in that the coaxial inner wall (5i) of the treatment chamber (3) is connected to an rf-generator (50) for generating a rf-plasma discharge.

4. Apparatus according to any of claims 1 to 3, characterised in that radially inside said inner wall surface (5i), there are provided additional systems, especially rotating drive means (80) for the carrier means and/or a pumping connector.

5. Apparatus according to any of claims 1 to 4, characterised in that the carrier means are linked with a continous rotating drive means.

6. Apparatus according to any of claims 1 to 5, characterised in that the carrier means (7,7a,8) defines a cylindrical surface, having a plurality of workpiece holders (13a) beeing distributed along said surface.

7. Apparatus according to any of claims 1 to 6, characterised in that a substantial part of the radial outer wall surface (5a) may be opened for charging and discharging the treatment chamber.

8. Apparatus according to any of claims 1 to 7, characterised in that at least one front terminal portion (4) of the treatment chamber (3) may be opened for charching and discharging the treatment chamber (3).

9. Apparatus according to any of claims 1 to 8, characterised in that the carrier means are defining a cylinder wall for one or several workpieces (13) by discrete carrier rods (8), being disposed substantially parallel to the axis (A) of the coaxial surface walls, or by a carrier cylinder (7).

10. Apparatus according to any of claims 1 to 9, characterised in that the treatment chamber (3) is substantially arranged with vertical axis (A), and comprising bearing means for rotatably bearing said carrier (7,7a,8) which are beeing disposed at the bottom of said treatment chamber (3), and preferably a drive means acts on said carrier means at the bottom of said treatment chamber.

11. Apparatus according to any of claims 1 to 10, characterised in that the carrier means (7,7a,8) comprising centraly rotatable bearing means and are preferably driven at the periphery.

12. Apparatus according to any of claims 1 to 11, characterised in that the carrier means comprising centraly radialy and peripheral axial bearing means or vice versa, and that the driving means acts preferably central or peripheral on the carrier means and then preferably forms at least part of one of said bearing means.

13. Apparatus according to any of claims 1 to 12, characterised in that the carrier means comprising a rotatable carrier plate (25), being formed so as to be elastically deformable by choosing the material and/or its structure, preferably comprising a spoked structure which is preferably supported peripheraly in the direction of the axis (A) of the treatment chamber.

14. Apparatus according to any of claims 1 to 13, characterised in that a driving motor for the carrier means act via a driving wheel (37) on the carrier means.

15. Apparatus according to any of claims 1 to 14, characterised in that workpiece holders mounted on the carrier means are electrically isolated arranged from other parts of the apparatus and are selectively set to an electrical potential.

16. Apparatus according to any of claims 1 to 15, characterised in that workpiece holders (13a) are beeing moved along said carrier means at substantially equal distance between the wall surfaces (3).

17. Apparatus according to any of claims 1 to 16, characterised in that workpiece holders (13a) on the carrier means beeing at floating eletrical potential.

18. Apparatus according to any of claims 1 to 17, characterised in that at least parts of the outer and/or inner wall (5a,5i) of the annular treatment chamber (3) and at least parts of workpiece holders (13a) beeing electrically mutualy independent as a three-electrode arrangement.

19. Use of the apparatus of any of claims 1 to 18 for the simultaneous treatment of two sides of optical workpieces, especially for the coating of the workpieces.

20. Use according to claim 19 for the simultaneous substantially equal coating of two sides of optical workpieces.

21. Use according to claim 19 or 20 for the coating of optical workpieces by plasmapolymerisation.

## Revendications

1. Installation de traitement sous vide pour des pièces à traiter, comprenant un espace de traitement cylindrique extérieur (3) et un dispositif de support rotatif (7, 7a, 8) pour plusieurs pièces (13) dans l'espace de traitement (3), lequel dispositif de support est relié à un entraînement en rotation, étant précisé que la paroi de l'espace de traitement est apte à être ouverte sur une grande surface pour permettre de charger et de décharger les pièces (13) dans l'espace de traitement (3), caractérisée en ce que l'espace de traitement (3) est défini par deux surfaces de paroi (5a, 5i) sensiblement cylindriques et coaxiales, et le dispositif de support (7, 7a, 8) dépasse entre les surfaces de paroi.

2. Installation selon la revendication 1, caractérisée en ce que l'espace de traitement (3) est conçu, sur sa surface intérieure et/ou extérieure radiale, comme une électrode circulaire annulaire destinée à produire une décharge de plasma dans l'espace de traitement (3).

3. Installation selon l'une des revendications 1 ou 2, caractérisée en ce que la paroi intérieure coaxiale (5i) de l'espace de traitement (3) est accouplée à un générateur haute fréquence (50) pour produire une décharge de plasma haute fréquence.

4. Installation selon l'une des revendications 1 à 3, caractérisée en ce que des éléments d'installation supplémentaires, notamment un entraînement en rotation (80) pour le dispositif de support et/ou un raccordement de pompe, sont prévus radialement à l'intérieur de la surface de paroi intérieure (5i).

5. Installation selon l'une des revendications 1 à 4, caractérisée en ce que le dispositif de support est relié à un entraînement en rotation continu.

6. Installation selon l'une des revendications 1 à 5, caractérisée en ce que le dispositif de support (7, 7a, 8) couvre une surface cylindrique sur laquelle sont répartis des porte-pièces (13a).

7. Installation selon l'une des revendications 1 à 6, caractérisée en ce que la surface de paroi radialement extérieure (5a) est apte à être ouverte sur une grande surface (2) pour le chargement et le déchargement de l'espace de traitement (3).

8. Installation selon l'une des revendications 1 à 7, caractérisée en ce qu'au moins une partie terminale frontale (4) de l'espace de traitement (3) est apte à être ouverte pour le chargement et le déchargement de l'espace de traitement (3).

9. Installation selon l'une des revendications 1 à 8, caractérisée en ce que le dispositif de support couvre une surface cylindrique à l'aide de supports discrets (8) qui sont sensiblement parallèles à l'axe (A) des surfaces de paroi coaxiales et qui sont prévus pour une ou plusieurs pièces (13), ou à l'aide d'un cylindre de support (7).

10. Installation selon l'une des revendications 1 à 9, caractérisée en ce que l'espace de traitement (3) est disposé sensiblement suivant un axe vertical (A), et il est prévu pour le dispositif de support (7, 7a, 8) des coussinets de pivotement disposés en bas par rapport à l'espace de traitement (3), et de préférence un contact entre l'entraînement et le dispositif de support.

11. Installation selon l'une des revendications 1 à 10, caractérisée en ce que le dispositif de support (7, 7a, 8) est monté mobile en rotation au centre et est entraîné de préférence dans la zone périphérique.

12. Installation selon l'une des revendications 1 à 11, caractérisée en ce que le dispositif de support est monté radialement au centre et axialement à la périphérie ou inversement, et en ce qu'un contact d'entraînement au centre ou à la périphérie est de préférence prévu avec le dispositif de support et constitue de préférence au moins un élément de l'un des montages mentionnés.

13. Installation selon l'une des revendications 1 à 12, caractérisée en ce que le dispositif de support comprend une plaque de support montée mobile en rotation (25) qui est apte à être déformée élastiquement grâce au choix du matériau et/ou à des déformations, qui présente de préférence une structure à rayons et qui est en appui de préférence à la périphérie dans le sens de l'axe (A) de l'espace de traitement.

14. Installation selon l'une des revendications 1 à 13, caractérisée en ce qu'un moteur d'entraînement prévu pour le dispositif de support agit sur celui-ci par l'intermédiaire d'une roue d'entraînement (37).

15. Installation selon l'une des revendications 1 à 14, caractérisée en ce que les porte-pièces sont montés sur le dispositif de support en étant isolés électriquement des autres éléments de l'installation et sont éventuellement mis de façon appropriée à un potentiel électrique.

16. Installation selon l'une des revendications 1 à 15, caractérisée en ce que les porte-pièces (13a) prévus sur le dispositif de support sont déplacés, sensiblement équidistants, entre les surfaces de paroi (3).

17. Installation selon l'une des revendications 1 à 16, caractérisée en ce que les porte-pièces (13a) prévus sur le dispositif de support fonctionnent à un potentiel flottant.

18. Installation selon l'une des revendications 1 à 17, caractérisée en ce que des parties au moins de la paroi extérieure et/ou intérieure (5a, 5i) de l'espace de traitement annulaire (3) et des parties au moins des porte-pièces (13a) sont aptes à fonctionner électriquement indépendamment les unes des autres comme dispositif à trois électrodes.

19. Utilisation de l'installation selon l'une des revendications 1 à 18 pour le traitement simultané de composants optiques sur deux côtés, en particulier pour le revêtement de ces composants.

20. Utilisation selon la revendication 19 pour le revêtement simultané et sensiblement identique de composants optiques sur deux côtés.

21. Utilisation selon l'une des revendications 19 ou 20 pour le revêtement de composants optiques grâce à la polymérisation par plasma.
